# EUROPEAN PATENT APPLICATION

(11) **EP 4 575 047 A1**
(43) Date of publication of application: **25.06.2025**
(21) Application number: 23217983.8
(22) Date of filing: 19.12.2023
(51) Int. Cl.: C30B 23/00, C30B 29/36

(54) **CRUCIBLE FOR PRODUCING A SIC VOLUME MONO CRYSTAL AND A METHOD FOR GROWING A SIC VOLUME MONO CRYSTAL**

(71) Applicant: SiCrystal GmbH, 90411 Nürnberg (DE)
(72) Inventor: Ecker, Bernhard, 90411 Nürnberg (DE); Müller, Ralf, 90411 Nürnberg (DE); Schuh, Philipp, 90411 Nürnberg (DE); Stockmeier, Matthias, 90411 Nürnberg (DE); Vogel, Michael, 90411 Nürnberg (DE)
(74) Representative: Grünecker Patent- und Rechtsanwälte PartG mbB

(57) **Abstract**

The present invention relates to a crucible with a cavity for growing a SiC volume mono crystal by sublimation growth in a direction of growth (Y). The crucible comprises an end wall (110) with a seed holder (112) for holding a SiC seed crystal in the cavity, the end wall (110) extending in a direction (r)perpendicular to the direction of growth (Y); a side wall (140) extending in the direction of growth (Y), the side wall (140) preventing permeation of a doping gas from an external into the cavity, the doping gas for doping the SiC volume mono crystal during the sublimation growth; and a diffusion region (114) allowing permeation of the doping gas from the external in the cavity, wherein the diffusion region (114) is located between the seed holder (112) and an edge (142) of the side wall (140).

## Description

The semiconductor material silicon carbide (SiC) is used for high frequency components and for special light-providing semiconductor components because of its excellent physical, chemical, electrical and optical properties, inter alia also as a starting material for power-electronic semiconductor components. SiC substrates, for example as discussed in US Patent US 8,747,982 B2, with as large substrate diameters (equal to or greater than 200 mm) and high quality are required for these components. A SiC volume mono crystal with large diameter and high quality is an object of the present description.

At least this objects is solved by the independent claims. Advantageous embodiments are solved by the dependent claims.

In more detail, a mono crystal is a material in which the crystal lattice of the entire sample is continuous and unbroken to the edges of the sample, with no grain boundaries. The absence of the defects associated with grain boundaries can give mono crystals unique properties, particularly mechanical, optical and electrical. These properties are industrially used in technological applications, especially in optics and electronics.

With the use of suitable source material, the SiC volume mono crystals can be grown, for example, by a physical vapor transport (PVT) process, which describes a vacuum deposition method which can be used to produce the mono crystals. PVT is characterized by a process in which the material transitions from a condensed phase to a vapor phase (i.e. the sublimating phase) and then back to a thin film condensed phase. The material is transported in the vapor phase from a source region to a seed region. The most common PVT processes are sputtering and evaporation. Further details of the PVT process can be found for example in the US Patent US 8,747,982 B2.

Disc-shaped mono crystal SiC substrates are cut out of the SiC volume mono crystal and are then provided during the manufacture of the components with at least one epitaxy layer in particular also consisting of SiC. In the subsequent epitaxial processes, thin single-crystalline layers (e.g. SiC, GaN) can first be deposited on the SiC substrates. The quality of this epitaxy layer decisively depends on the local orientation of the mono crystalline substrate, in other words depends on the SiC substrate cut out from the SiC volume mono crystal. If local deviations from the optimal orientation occur in the crystal structure of the SiC substrate, this may propagate into the epitaxy layer. The epitaxy layer then also contains local defects, which ultimately can lead to poor properties of the end products, in other words the semiconductor components.

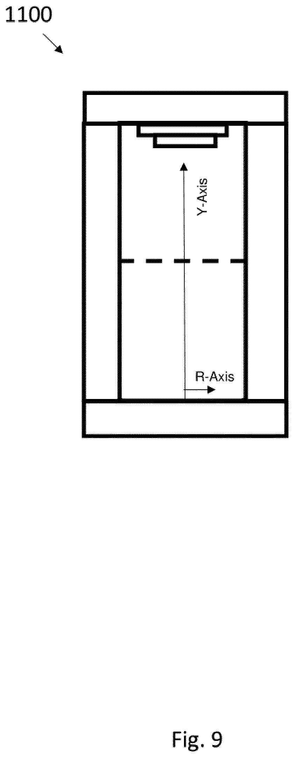

As shown in Fig. 9, PVT crystal growth is performed in a crucible 1100. A crucible is a container in which materials, e.g. SiC, can be subjected to very high temperatures (above 2000 °C), e.g. temperature allowing to sublimate SiC. In particular, the crucible is made of a material that withstands temperatures high enough to melt and/or sublimate its contents.

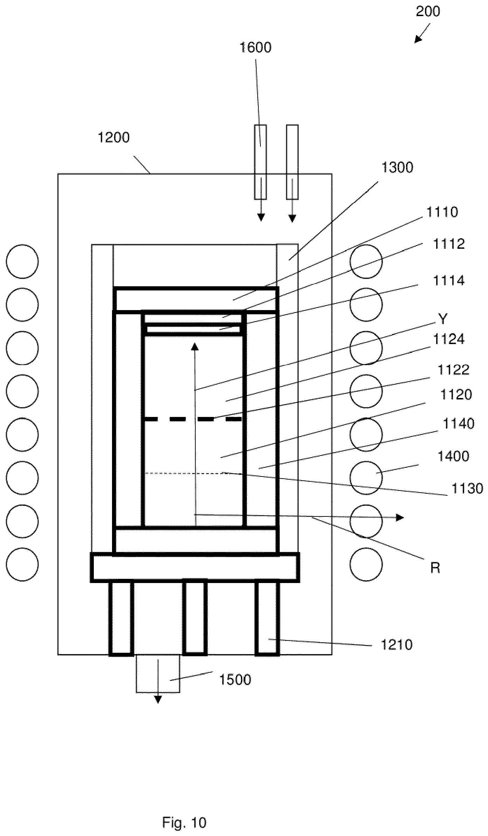

As shown in Fig. 10, the crucible 1100 is placed in a tubular container 1200, which can be designed as a quartz glass (adapted for the later described induction heating) or stainless steel (adapted for the later described resistance heating) and forms a reactor, which is the core of the plant 2000. For example, the crucible is hold by stand 1210 arranged in the tubular container 1200. The tubular container 1200 is a machine used to carry out processes requiring elevated temperature and pressure in relation to ambient pressure and/or temperature.

The actual crystal growth takes place in the reactor. The growth structure comprises an insulation 1300, which is arranged around the crucible.

The walls of the crucible can comprise materials such as graphite and carbon. These material allow that the crucible allows to heat the SiC to growth temperatures of over 2000°C.

In particular, for growing the SiC volume mono crystal, a SiC seed crystal 1114 is arranged at a seed holder 1112, which is arranged at an end wall 1110 of the crucible before the beginning of growth. In more detail, the SiC seed crystal 1114 is arranged in a crystal growth region 1124 of the growth crucible 1100, which is preferably completely closed, in particular at least during the growth.

Powdery SiC source material is introduced into a SiC storage region 1120 of the growth crucible. A boundary of the SiC storage region 1120 at the start of the growth process is indicated by the thick dashed line 1122. The boundary is for example a wall made of porous graphite. During the growth, by sublimation of the powdery SiC source material and by transport of the sublimated gaseous components into the crystal growth region 1124, i.e. along the Y-Axis, an SiC growth gas phase is produced there, and the SiC volume mono crystal having a central center longitudinal axis along the Y-Axis grows by deposition from the SiC growth gas phase onto the SiC seed crystal 1114.

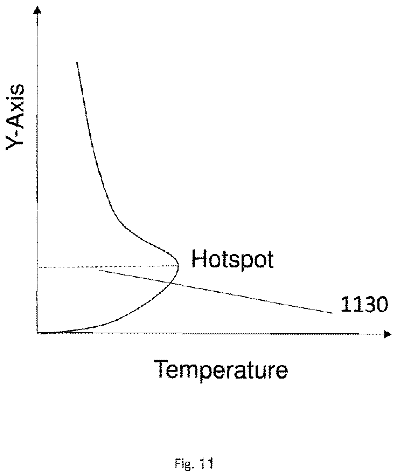

To grow the SiC volume mono crystal, a temperature distribution along the Y-Axis as shown in Fig. 11 is realized in the crucible. In particular, a dashed line 1130 indicates in Figs. 10 and 11 the highest temperature. In particular, the highest temperature is located in the middle of the SiC storage region 1120.

As shown in Fig. 10, heating can be provided either by induction coils 1400 placed outside the tubular container 1200. In particular, the induction coils 1400 are arranged along a circumferential direction at a radius R_{coil} along a radial axis R. Alternatively, according to a solution not shown, resistance heaters can be placed inside the reactor 1200.

Induction heating is the process of heating electrically conductive materials by electromagnetic induction, through current passing through the inductor 1400 that creates an electromagnetic field within the coil to heat up the material in the SiC storage region 1120 directly and/or to heat up a side wall 1140 of the crucible to indirectly heat the SiC in the storage region. The side wall 1140 of the crucible extends along the circumferential direction at a Radius R_{sidewall} along the direction of growth, i.e. the Y-Axis. The insulation 1300 thermally insulates the crucible and the cavity formed inside the crucible.

The temperature can be measured by one or more not shown pyrometers or by one or more thermocouples. In particular, the temperature is measured in the chamber formed by the reactor 1200 but outside the crucible. The vacuum-sealed reactor 1200 may be evacuated by one or more not shown vacuum pumps via the outlet 1500. Furthermore, the system can be supplied with inert and/or doping gases (e.g. nitrogen) via one or more gas supply lines 1600 and the pressure in the system can be measured and controlled by not shown pressure sensors.

Process parameters such as pressure, temperature, and gas flows can be set, controlled and archived by a computerized system control. The plant control system communicates with all the components involved (e.g. a converter, a pyrometer, a vacuum control valve, a mass flow control (MFC) for providing the doping gases, and the pressure sensors).

As discussed above, the SiC single crystals or the substrates produced from them shall be of high quality for the subsequent epitaxy processes. For this purpose, it shall be ensured that doping gases such as nitrogen are present as a doping gas in the growth space in a controlled manner throughout the entire growth period and can be incorporated into the crystal lattice of the growing SiC single crystal. An uneven doping gas concentration over the growth period and thus an uneven incorporation into the single crystal leads to increased scrap during processing to SiC substrates. In more detail, doping gases such as nitrogen influence the brittleness of the SiC single crystal. An uneven incorporation of doping gas, in particular nitrogen, into the crystal lattice leads to cracks in the crystal processing or to wafer scrap due to too high values of Bow and Warp of the SiC substrates. As used herein, bow and warp of semiconductor wafers and substrates are measures wafer flatness.

Doping gas can be input into the system by two different methods: Use of gas-permeable cultivation crucibles or gas-impermeable cultivation crucibles, whereby gas-permeable crucibles are generally used more frequently.

When using gas-permeable growth setups, gas supply lines for inert gas and dopant gases controlled by MFCs, usually lead into the reactor chamber, and there is a concentration balance between the nitrogen content in the reactor chamber and inside the growth crucible. The following problems exist in this process: The gas permeability of the crucible and the diffusion of nitrogen changes with the temperature. For example, due to the temperature-dependent pore expansion in the graphite the concentration in the crucible changes over the duration of growing the SiC volume mono crystal as growing is usually carried out with temperature ramps to compensate for effects of powder depletion and the like. Growing the SiC volume mono crystal at temperature ramps also leads to different nitrogen incorporation into the crystal lattice, as this also occurs as a function of temperature.

This has the effect that varying nitrogen concentrations during the growing period lead to the mentioned exploitation-reducing factors crystal cracks and poor geometry values (bow and/or warp).

In view of the above, the problem lies in a uniform and controlled supply of nitrogen into the crystal growth space of the crucible. With the increasing diameter of the crystals (200mm and larger) and the associated increase in the size of the growth setups, new solution approaches are necessary in view of these problems. At the same time the PVT process requires vacuum tight framework conditions on the process conditions and the materials used.

Existing solutions propose to provide a gas-permeable crucible, e.g. a crucible made of graphite. The nitrogen content in the reactor is controlled, e.g. by an MFC, and selectively introduced into the reactor. In this solution the growth crucible located in the reactor has a certain permeability so that nitrogen can diffuse from the reactor into the growth crucible. However, there is usually no way to control the nitrogen content in the crucible, which obeys the temperature-dependent diffusion law. Likewise, the incorporation of nitrogen (in the growth space of the crucible) into the SiC crystal lattice obeys the temperature-dependent laws, without it being possible to influence the incorporation mechanism of the nitrogen in any other way. Due to the permeability of the crucible, gaseous components (Si and C-containing compounds) of the source material can also enter the reactor by diffusion along the radial temperature gradient from the crucible. There they are deposited on the colder areas, e.g. in the insulation or the reactor wall, resulting in aging and wear.

Alternatively, gas non permeable crucibles e.g. crucible completely made of TaC, can be used. In this design, the nitrogen must be fed directly into the gas non permeable crucible through piping, for example, which leads to a significantly increased process effort and significantly higher manufacturing costs. If the dopant nitrogen is not supplied internally via an additional gas feed, it is not possible to produce N-doped SiC crystals in it, which are used in power electronics. In addition, it is disadvantageous that pre-process-related impurities (e.g. water, Na, Ca...) present in the crucible, e.g. the impurities are entering the crucible during preparing the crucible with the source material and the seed before placing the crucible in the reactor, cannot be removed from the system at the start of the process by a bake out step under vacuum by diffusion through the crucible wall. However, the advantage of this design is that no gaseous components of the source material can enter the reactor by diffusion along the radial temperature gradient from the crucible and cause aging of the insulation or wear of the reactor.

The object of the invention is in particular to provide a solution for a crucible, which allows to provide a doping gas with a constant concentration. In particular, temperature effects caused by temperature ramps shall be avoided. A further, object is to minimize the process complexity, for example by providing pipes feeding the nitrogen directly into a cavity formed in the crucible. Furthermore, the effects of disturbing materials in the crucible shall be avoided.

According to a general example, a specifically arranged diffusion region allowing permeation of the doping gas from the external in the cavity solves the problem. In more detail, the diffusion region according to the general example is located between a non-permeable seed holder at an end wall and an edge of a non-permeable side wall.

In particular, the above defined diffusion region is arranged only in a region that is subject to the smallest temperature gradients during a cycle of cultivation. In view of the diffusion region being almost constant in temperature during the cycle of cultivation, the amount of doping gas in the cavity of the crucible is constant, and thus, the control of incorporation of the doping gas into the crystal lattice is improved.

The permeability of the cultivation crucible with respect to the permeability of doping gas is modified by coating and/or infiltration in such a way that the side wall, i.e. the radial boundary, of the cultivation crucible in the area of the source region and growth space becomes almost non-permeable to the doping gas. At the same time, the seed holder arranged at the end wall of the cultivation crucible provides a barrier to nitrogen entry over its entire area.

This leads to the design of the cultivation crucible, in which the diameter of the crucible is larger than the diameter of the inserted SiC seed and/or a diffusion gap is formed between the end wall and an edge of the side wall. The resulting doping gas ring between the outer SiC seed diameter and the inner crucible diameter and/or the resulting doping gas diffusion gap acts as a doping gas diffusion surface and/or doping gas diffusion gap within the cultivation setup according to the invention.

More specifically, a first aspect relates to a crucible with a cavity for growing a SiC volume mono crystal by sublimation growth in a direction of growth.

With regard to the description of the crucible is referred to the above description. In particular, the crucible forms in its interior the cavity in which the SiC volume mono crystal grows. An inner surface of the crucible faces the cavity. An outer surface of the crucible faces the above described reactor, namely is surrounded by the chamber formed by the reactor.

Advantageously, the crucible has a prism shape. A prism is a polyhedron comprising an n-sided polygonal base, a second base which is a translated copy (rigidly moved without rotation) of the first, and n other faces forming a side wall, joining corresponding sides of the two bases. Thus, a closed cavity is realized. This prism shape enables that the SiC volume mono crystal can be easily removed from the cavity, namely parallel to the faces forming the side wall. Frequently, the crucible has a cylindrical shape, i.e. the bases have a circular cross section.

Notably, geometries that can be used several times are advantageous because the cost of treating/coating a side wall, which will be described later, are high. Thus, especially the geometry of the prism, in particular the geometry of a cylinder, is advantageous because the SiC volume mono crystal can be extracted along the direction of growth and dead spaces in the cavity can be reduced.

With regard to the description of the SiC volume mono crystal is referred to the above description. For the description of the sublimation growth is referred to the above description. In particular, in the case of the cylinder having a prism shape, the growth direction is perpendicular to the extension direction of the base, i.e. parallel to the direction of the faces forming the side walls.

According to the first aspect, the crucible comprises an end wall, e.g. the first base of the prism shape. The end wall comprises a seed holder for holding a SiC seed crystal in the cavity. The seed holder and the SiC seed crystal are in the following referred to as a holder-seed unit. The holder-seed unit reduces the permeability of the end wall for the doping gas. In particular, in view of the growing SiC volume mono crystal, the permeability is reduced in view of the increasing thickness. In other words, at least a part or only a part of the end wall is at least non-permeable for a doping gas.

The seed holder can be for example formed from a polycrystalline SiC. The coefficients of heat expansion of the two components of the holder-seed unit, namely of the seed holder and the SiC seed crystal, are then very similar to one another, and so the force effects caused by temperature of the seed holder on the SiC seed crystal are particularly small. However, another holder material is basically also possible, for example a graphite material.

The end wall is extending perpendicular to the direction of growth. This enables that after completion of growing, the SiC volume mono crystal can be easily extracted, namely translating the end wall with the holder-seed unit along the direction of growth. In particular, in the case of the crucible having a cylindrical shape, the end wall extends in a radial direction.

Further, according to the first aspect, the crucible comprises a side wall extending in the direction of growth. For example, in case of the crucible having a cylindrical shape, the side wall forms a cylindrical surface extending along a circumferential direction around the direction of growth and in the direction of growth. In this case, the crucible may have additionally a bottom wall opposing the end wall, and thus, the cavity is closed. However, the bottom wall can have any shape for closing the cavity of the crucible.

Further, the side wall is designed to prevent permeation of a doping gas from an external source into the cavity. Permeation (also called imbuing) is the penetration of a permeate (a fluid such as a doping gas) through a part such as a wall or a contact region of the crucible. It is directly related to the concentration gradient of the permeate, a material's intrinsic permeability, and the materials' mass diffusivity. The process of permeation involves the diffusion of molecules, called the permeant, through an interface such as the side wall. Permeation works through diffusion; the permeant will move from high concentration to low concentration across the interface. Preventing permeation means that the amount of permeate through this part of the side wall is negligible (or at least less) compared to another part, i.e. the later described diffusion region.

A doping gas enables doping of a material. Doping is the intentional introduction of impurities into an intrinsic semiconductor, i.e. the SiC volume mono crystal, for the purpose of modulating its electrical, optical and structural properties. The doped material is referred to as an extrinsic semiconductor.

According to the first aspect, the doping gas is used for doping the SiC volume mono crystal during the sublimation growth. In more detail, in the SiC growth gas phase, doping substances are provided. Doping gases (also referred to as doping substances) are for example nitrogen (N) Aluminum (Al), Vanadium (V) and/or Boron (B). The doping substance is supplied in gaseous or solid form. For example, doping metals or metalloids such as Al, V, and B are provided in solid form, for example in the crucible with the source material. Additionally or alternatively, the metals and/or metalloids may be provided in gaseous form and can enter through diffusion through the crucible. Advantageously, the SiC volume mono crystal is an n-doped SiC crystal with nitrogen. However, another doping is also basically possible. Advantageously the polytype of the SiC is 4H. 4H is particular advantageous for the use of power electronics. However, another SiC polytype is also basically possible.

To provide the doping gas, according to the first aspect, a diffusion region allowing permeation of the doping gas from the external into the cavity is provided. In more detail, the diffusion region is located between the seed holder and an edge of the side wall. In more detail, the edge of the side wall is abutting to the end wall. Thus, during the growing phase, the diffusion region is arranged in a location which experiences smaller changes in temperature than for example the side wall, which is close to the heated SiC storage region. For further details of the temperature distribution is referred to the above description with reference to Figs. 10 and 11. Examples of the realization of the diffusion region are discussed below in further aspects.

According to a second aspect, in addition to the first aspect, the side wall comprises or consists of a material for preventing permeation of the doping gas, the material comprising at least one of: graphite with a density of equal to or greater than 1.8 g/cm³, glass like carbon, and refractory metal carbide. As used herein, refractory metal carbide capable endure the high temperatures during the PCT process. According to an advantageous aspect, the material comprises graphite with a density of equal to or greater than 1.85 g/cm³. Additionally or alternatively, the material comprises graphite with a density of equal to or less than 1.95 g/cm³.The density of the graphite is controlled by using processes such as isostatic pressing. Thus, graphite with a lower density than natural graphite can be realized. Advantageously, the side wall comprises or consists of a combination of the before mentioned materials. Thus, the material of the side wall can prevent the permeation of gases. This avoids the process step of coating the side wall. Thus, the permeation rate of the crucible can be adapted by an infiltration process.

As used herein, graphite is a crystalline form of the element carbon.

As used herein, glass-like carbon, often referred to as glassy carbon or vitreous carbon, is a non-graphitizing, or non-graphitizable, carbon which combines glassy and ceramic properties with those of graphite. The most important properties are high temperature resistance, hardness, low density, low electrical resistance, low friction, low thermal resistance, extreme resistance to chemical attack, and impermeability to gases and liquids.

As used herein, a carbide or refractory metal carbide usually describes a compound composed of carbon and a refractory metal.

According to a third aspect, in addition to any of the preceding aspects, the side wall comprises a layer at least on one of an inner surface and an opposing outer surface, the layer for preventing permeation of the doping gas, the inner surface facing cavity. Thus, the permeation rate of the crucible can be adapted by a coating process.

Notably, as discussed with reference to the prism geometries that can be used several times, providing the crucible with layers is advantageous because the cost of treating/coating a side wall is less expensive than using a crucible made of or comprising a graphite. Thus, especially the geometry of the prism, in particular the geometry of a cylinder, in combination with a layer is advantageous.

Advantageously, according to a fourth aspect in addition to the third aspect, the layer comprises at least one of: a photoresist, a graphitized sugar layer, TaC, WC, and Ta4HfC5. These materials can be applied as thin films, from solution or from gas phase. These layers are more stable in temperature, in the chemical properties, and are more gas tight than graphite.

Advantageously, according to a fifth aspect in addition to the third or fourth aspect, the layer has a thickness of equal to or greater than 0.5 µm, preferably the thickness is equal to or greater than 1 µm, even more preferably the thickness is equal to or greater than 2 µm. Optionally, wherein the maximum thickness is equal to or less than 5 µm.

According to a sixth aspect, in addition to any of the preceding aspects, the side wall comprises a layered structure for preventing permeation of doping gas, the layered structure comprises alternating first layers and second layers. In the case of the cylindrical shape, each layer forms a cylindrical surface. At least two layers of the first material and two layers of the second material are provided. Advantageously, the first layers comprise graphite and the second layers comprise refractory metal carbide.

According to a seventh aspect, in addition to any of the preceding aspects, the end wall comprises the diffusion region. For example, in the case of a circular end wall, the diffusion region forms an annular ring around the seed holder.

According to this example, the diameter of the crucible is larger than the diameter of the inserted seed holder. The resulting doping gas permeable diameter between the outer seed holder diameter and the inner crucible diameter acts as a doping gas diffusion surface within the cultivation setup according to the first example.

As the diameter of the seed holder used increases, the size of the diffusion region can also be adjusted by adjusting the growth crucible so that an amount of doping gas corresponding to the growing crystal volume and the desired doping level is available.

According to an eighth aspect in addition to the seventh aspect, an area of the diffusion region relative to an inner surface of the end wall is equal to or greater than 20 % and equal to or less than 40 %, the inner surface of the end wall facing the cavity. This applies in particular for SiC volume mono crystals with a diameter of larger than 200 mm perpendicular to the direction of growth. The inventors found out that these ratios are sufficient to provide the necessary permeation ratios.

According to a ninth aspect, in addition to any of the preceding aspects, the crucible further comprises a sealing element, the sealing element for sealing a contact region between the end wall and the edge of the side wall thereby controlling, e.g. reducing, the permeation of the doping gas through the contact region.

The sealing of the end wall and the side wall, and possibly also the sealing of the bottom wall and the side wall if the latter is not designed as a "pot", can be optimized by introducing the sealing element comprising or consisting of graphite, so that the effect of a doping gas diffusion channel in the contact region is eliminated. Then the effect of the channel at the end wall and/or end wall and bottom wall can be neglected and the doping gas diffusion can only be considered via the diffusion region next to the seed holder.

According to a tenth aspect, in addition to any of the preceding aspects, the crucible further comprises a fastening element, the fastening element for fastening the end wall to the side wall and thereby adjusting the permeation rate of the doping gas through a contact region between the end wall and the edge of the side wall. Thus, the thickness of a diffusion gap arranged in the contact region can be defined, for example by fixing the fastening element, e.g. a screw, with a defined torque.

According to an eleventh aspect, in addition to the tenth aspect, during the growth of the SiC volume mono crystal, a gap is formed between the end wall and the edge of the side wall, the gap for passing doping gas. This enables that the seed holder diameter is identical to the inner diameter of the crucible. The diffusion region is realized by the gap, which forms a doping gas diffusion channel. The channel width can be defined by the gap remaining between the end wall and the side wall during fastening the fastening element, for example screwing at a defined torque, and possibly also between a base wall and the side wall if the latter is not designed as a "pot".

Advantageously, the gap is equal to or greater than 0.1 mm and equal to or less than 0.5 mm. The gap width is measured along a radial and/or longitudinal axis of the crucible. The gap surrounds in the circumferential direction the crucible thereby forming an annular ring, wherein the annular ring connects an outer surface of the crucible with an inner surface of the crucible.

This applies in particular for SiC volume mono crystals with a diameter of larger than 200 mm perpendicular to the direction of growth.

According to a twelfth aspect, in addition to any of the preceding aspects, the crucible further comprises a bottom wall, wherein the bottom wall extends perpendicularly to the direction of growth so that the bottom wall together with the end wall and the side wall, encloses the cavity. This is one possible solution for closing the cavity.

In particular, according to a first example of the twelfth aspect, the bottom wall comprises a second seed holder for holding a second SiC seed crystal in the cavity and the crucible comprises a second diffusion region allowing permeation of the doping gas, the second diffusion region being located between the second seed holder and a second edge of the side wall. With regard to the description of the second seed holder, the second SiC seed crystal, and the second diffusion region is referred to the above description of the seed holder, the SiC seed crystal and the diffusion region. This solution enables a double crystal design. For example, if a stand is connected to the bottom wall, a gas-permeable insulation material is introduced between the stand and the growth crucible, so that a second doping diffusion region can also be realized in this location. Alternatively, a perforated or porous stand can be used.

Alternatively, according to a second example of the twelfth aspect, the bottom wall is not detachably connected to the side wall thereby forming a pot, the pot preventing permeation of a doping gas from an external into the cavity. Optionally, an outer surface of the bottom wall is connected to a stand, the stand for holding the crucible in a growth arrangement and thereby the stand preventing the permeation of the doping gas from the external into the cavity through the bottom wall, the outer surface facing the external. A non permeable stand makes it superfluous of treating the bottom wall to become non permeable.

A thirteenth aspect relates to a growth arrangement. The growth arrangement comprises a crucible according to any of the preceding aspects, a reactor forming a chamber, wherein the crucible is arranged in the chamber; and a gas inlet for feeding the chamber with the doping gas. For the description of the reactor is referred to the above description. The gas inlet may be, for example, a valve, a permeable membrane, or the like.

Advantageously, the growth arrangement of the thirteenth aspect further comprises at least one of a heating, wherein the heating surrounds the side wall to inductively heat the side wall. For the description of the induction heating is referred to the above. Additionally or alternatively, the growth arrangement further comprises a gas outlet for connecting to a vacuum pump for reducing the pressure in the chamber. For the description of the gas outlet is referred to the description of the gas inlet. In particular, the gas outlet can be used to control the low pressure, i.e. the vacuum, in the reactor chamber. Further, through the outlet bake out gases can be extracted reducing contamination of the reactor.

A fourteenth aspect relates to a method of growing a SiC volume mono crystal in a cavity by sublimation growth in a direction of growth, the method comprising the steps of:
Providing at least one SiC seed crystal in the cavity, wherein the SiC seed crystal is arranged at an end wall provided with a seed holder for holding the SiC seed crystal, the end wall extending perpendicular to the direction of growth;
Closing the cavity with a side wall extending in the direction of growth, the side wall preventing permeation of a doping gas from an external into the cavity, the doping gas for doping the SiC volume mono crystal during the sublimation growth; and
Doping the SiC volume mono crystal with the doping gas, wherein the doping gas is diffused through a diffusion region allowing permeation of the doping gas from the external in the cavity, the diffusion region being located between the seed holder and an edge of the side wall.

For the description of the parts referred to in the fourteenth aspect, reference is made to the description of the above described first to thirteenth aspect. In particular, for example two SiC seed crystals can be provided in the cavity. For the description of two SiC seed crystals is referred to the above description.

A fifteenth aspect relates to a method, the method comprising the steps of:
Providing a crucible according to any of the first to twelfth aspects or a growth arrangement according to the thirteenth aspect, and
Growing the SiC volume mono crystal with the method of the fourteenth aspect.

The invention will now be described in greater detail and in an exemplary manner using advantageous aspects and with reference to the drawings. The described aspects are only possible configurations in which, however, the individual features as described above can be provided independently of one another or can be omitted.

The accompanying drawings are incorporated into the specification and form a part of the specification to illustrate several embodiments of the present invention. These drawings, together with the description, serve to explain the principles of the invention. The drawings are for the sole purpose of illustrating the preferred and alternative examples of how the invention can be made and used, and are not to be construed as limiting the invention to the illustrated and described embodiments only. Furthermore, several aspects of the embodiments, individually or in different combinations, may form solutions according to the present invention. Thus, the embodiments described below may be considered either alone or in an arbitrary combination thereof.

The described embodiments are merely possible configurations and it must be borne in mind that the individual features as described above can be provided independently of one another or can be omitted altogether while implementing this invention. Further features and advantages will become apparent from the following more detailed description of the various embodiments of the invention, as illustrated in the accompanying drawings, in which like references refer to like elements, and wherein:
In the figures, are:
- **FIG. 1**: a crucible with an infiltrated side wall with;
- **FIG. 2**: a crucible with a coated side wall;
- **FIG. 3**: a crucible with a coated and infiltrated side wall;
- **FIG. 4**: a crucible for growing more than one SiC single crystal;
- **FIG. 5**: a crucible with a fastening element;
- **FIG. 6**: a detail of Fig. 5 with a sealing element;
- **FIG. 7**: a detail of Fig. 5 with a diffusion channel;
- **FIG. 8**: a flow diagram for growing a SiC volume mono crystal;
- **FIG. 9**: a sectional view of a crucible;
- **FIG. 10**: a sectional view of the crucible of Fig. 9 arranged in a reactor; and
- **FIG. 11**: a temperature profile of the reactor of Fig. 10.

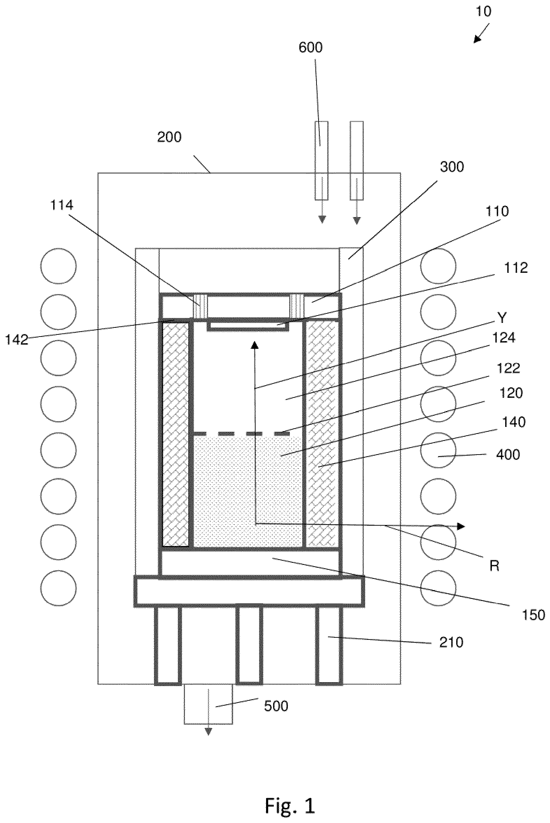

The invention is now described with reference to the Figures and first with reference to Fig. 1, which is similar to above described Fig. 10. In more detail, Fig. 1 shows a growth arrangement 10 with a crucible and a reactor 200 forming a chamber, wherein the crucible is arranged in the chamber.

The crucible comprises a cavity for growing a not shown SiC volume mono crystal by sublimation growth in a direction of growth Y The crucible comprises an end wall 110 with a seed holder 112 for holding a not shown SiC seed crystal in the cavity. The end wall 110 extends perpendicular to the direction of growth Y. In other words, the end wall 110 extends in a radial direction R. In more detail, the not shown SiC seed crystal is arranged in a crystal growth region 124 of the growth crucible. Further, the crucible comprises a side wall 140 extending in the direction of growth Y and a bottom wall 150. The end wall 110, the side wall 140, and the bottom wall 150 enclosing the cavity for growing the SiC volume mono crystal.

Powdery SiC source material is arranged into a SiC storage region 120 of the crucible. A border of SiC storage region 120 at the starting of the growth process is indicated by the thick dashed line 122. As described above, during the growth, by sublimation of the powdery SiC source material and by transport of the sublimated gaseous components into the crystal growth region 124, i.e. along the Y-Axis, an SiC growth gas phase is produced there, and the SiC volume mono crystal having a central center longitudinal axis along the Y-Axis grows by deposition from the SiC growth gas phase on the SiC seed crystal.

The crucible is hold by a stand 210 in the reactor 200. Further, an isolation 300 encloses the crucible. The growth arrangement further comprises an induction heating 400, a gas outlet 500, and a gas inlet 600.

Further, the end wall 110 comprises a diffusion region 114 allowing permeation of the doping gas from the external in the cavity. The diffusion region 114 is located between the seed holder 112 and an edge 142 of the side wall 140. The edge 142 of the side wall 140 abuts to the end wall 110. In more detail, the diffusion region forms an annular ring around the seed holder 112. According to the example, an area of the diffusion region relative to an inner surface of the end wall 110 is equal to or greater than 20 % and equal to or less than 40 %, the inner surface of the end wall 110 facing the cavity. According to a further example, an area of the diffusion region relative to an inner surface of the end wall 110 is equal to or greater than 25 % and equal to or less than 35 %, the inner surface of the end wall 110 facing the cavity.

Thus, the arrangement of the diffusion region 114 at the end wall 110 improves the control of the amount of doping that is supplied in the cavity. In particular, the heater 400 heats in particular the SiC storage region 120, which experiences high temperature changes while the diffusion region 114 experiences small temperature changes during a growing cycle. Thus, effects caused by temperature dependent permeation rates of the end wall 110 can be reduced.

Further, the side wall 140 is designed to prevent permeation of a doping gas from an external into the cavity, the doping gas for doping the SiC volume mono crystal during the sublimation growth. According to the example shown in Fig. 1, the side wall 140 comprises a material for preventing permeation of doping gas. In particular, the side wall 140 is infiltrated with a material for preventing permeation of doping gas. The material comprises for example at least one of: graphite with a density of equal to or greater than 1.8 g/cm³, glass like carbon, and metal carbide. Advantageously, the material comprises graphite with a density of equal to or greater than 1.85 g/cm³. Additionally or alternatively, the material comprises graphite with a density of equal to or less than 1.95 g/cm³. For example, the material comprises graphite with a density of equal to or less than 1.95 g/cm³ and equal to or greater than 1.8 g/cm³, advantageously equal to or greater than 1.85 g/cm³.

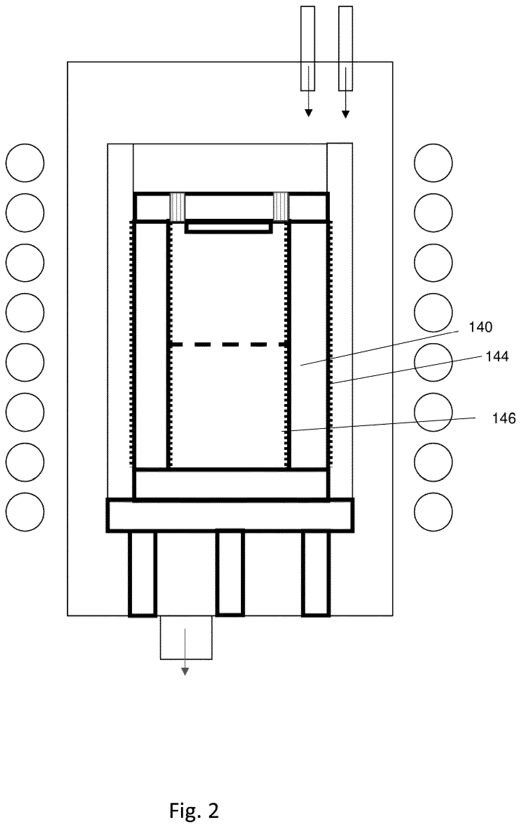

An alternative to a side wall 140 comprising a material for preventing permeation of doping gas is shown in Fig. 2. Fig. 2 is almost identical to Fig. 1. Fig. 2 differs from Fig. 1 in view of the side wall 140. According to the example shown in Fig. 2, the side wall 140 can comprise an insulating layer 146 on an inner surface and an insulating layer 144 at an opposing outer surface. Each of the layers 144 and 146 prevents the permeation of the doping gas. The inner surface faces the cavity. For example, the layer comprises at least one of: a photoresist, a graphitized sugar layer, TaC, WC, and Ta4HfC5 or other refractory metal carbides and/or combinations thereof. According to an example, the layer has a thickness of equal to or greater than 0.5 µm, preferably the thickness is equal to or greater than 1 µm, even more preferably the thickness is equal to or greater than 2 µm. Additionally or alternatively, the maximum thickness is equal to or less than 5 µm.

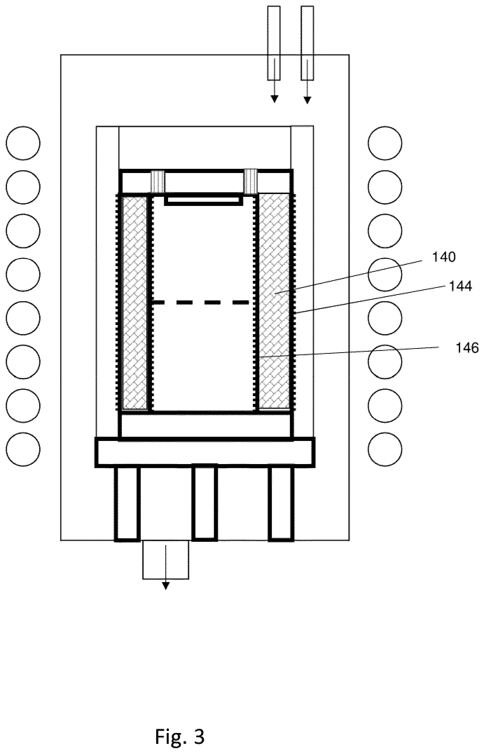

A further alternative to adjust the permeation rate of the side wall 140 of Fig. 1 is shown in Fig. 3. According to the example shown in Fig. 3, the side wall 140, which comprises non permeable material, additionally comprises insulating layers 144 and 146. For the description of the insulating layers is referred to the above description of Fig. 2.

In the examples disclosed with reference to Figs. 1 to 3, the bottom wall 150 extends in a direction R perpendicular to the direction of growth so that the bottom wall 150 encloses together with the end wall 110 and the side wall 140 the cavity.

According to the examples disclosed with reference to Figs. 1 to 3, the bottom wall 150 is non permeable for the doping gas. For example, the bottom wall 150 comprises a similar material or layer as the side wall 140.

Additionally or alternatively, the stand 210 is made of a non permeable material. In more detail, an outer surface of the bottom wall 150 is connected to the stand 210. The stand holds the crucible in the growth arrangement 10. Thus, the stand 210 can prevent the permeation of the doping gas from the external into the cavity through the bottom wall 150.

Additionally, the bottom wall 150 can be not detachably connected to the side wall 140 thereby forming a pot. The pot prevent permeation of the doping gas from an external into the cavity. Non detachable means that the bottom wall 150 and the side wall 140 are designed in such a way that they cannot be removed without causing damages.

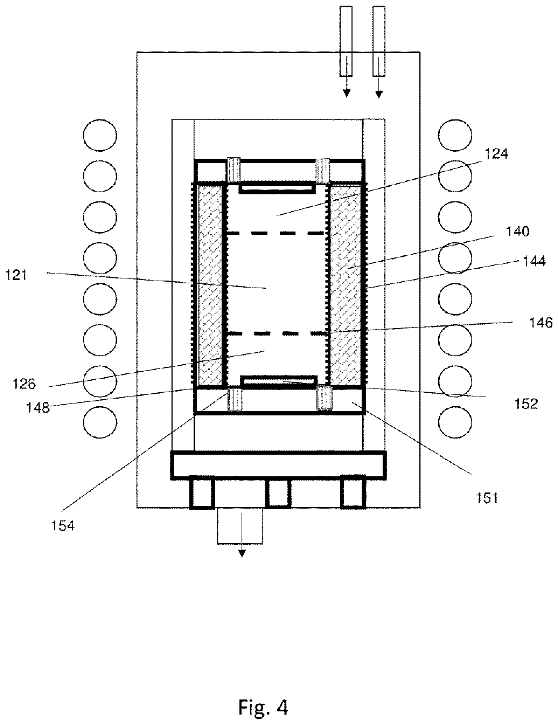

An alternative to a bottom wall 150 of Figs. 1 to 3 is shown in Fig. 4. Fig. 4 is almost identical to Fig. 3. Fig. 4 differs from Fig. 3 in view of the bottom wall 151 and the SiC storage region 121. In particular, in addition to the first crystal growth region 124 of Figs. 1 to 3, Fig. 4 provides as second crystal growth region 126. The first crystal growth region 124 is arranged at a first end in the crucible along the direction of growth and second crystal growth region 126 is arranged at a second opposing end the direction of growth in the crucible. Thus, two crystals can be grown within one cycle.

Further, the bottom wall 151 comprises a second seed holder 152 for holding a second, not shown, SiC seed crystal in the cavity and the crucible comprises a second diffusion region 154 for allowing permeation of the doping gas, the second diffusion region being located between the second seed holder 152 and a second edge of the side wall 148. In other words, the bottom wall 151 as shown in Fig. 4 is similar to the end wall 110 described above in Figs. 1 to 3.

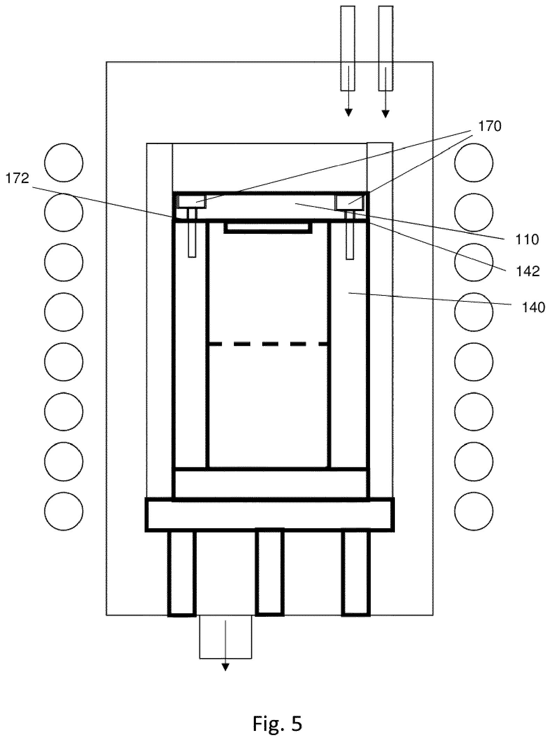

A further aspect of the crucible is shown in Fig. 5. In particular, Fig. 5 is similar to Figs. 1 to 3 and additionally comprises at least one fastening element 170. The fastening elements 170 fasten the end wall 110 to the side wall 140. For example, the fastening elements 170 are screws. By adjusting the torque, the permeation rate of the doping gas through a contact region 172 formed between the end wall 110 and the edge 142 of the side wall 142 can be adjusted. The example of Fig. 5 may be adapted to the example shown in Fig. 4. In particular, the bottom wall 151 can be fastened with a fastening element to the side wall 140.

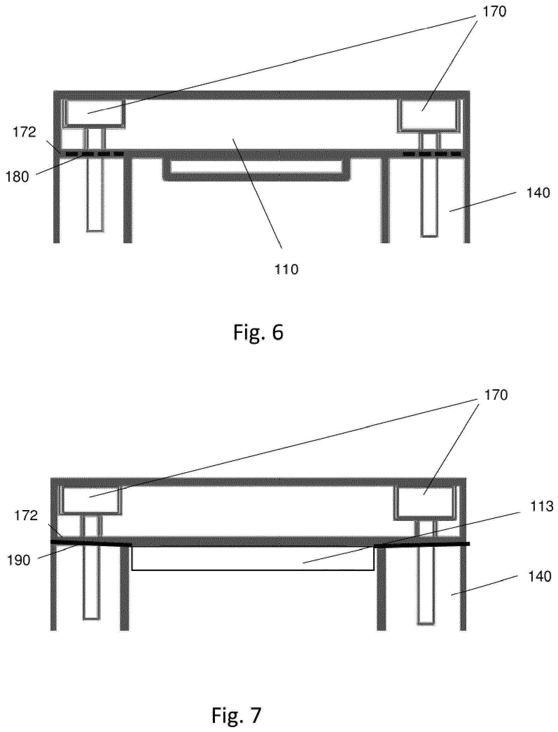

Details of Fig. 5 are shown in Figs. 6 and 7. In particular, Fig. 6 shows the crucible of Fig. 5, wherein addition a sealing element 180 is provided. The sealing element seals the contact region 172 between the end wall 110 and the edge of the side wall 140. Thus, the sealing element 180 reduces the permeation of the doping gas through the contact region 172. Alternatively, as shown in Fig. 7, a gap 190 is formed between the end wall 110 and the edge of the side wall 140. The gap enables passing doping gas form the external into the cavity. This may be advantageous in the case where the diameter of the seed holder 113 is as large (or nearly as large) as the inner diameter of the crucible. For example, the gap is equal to or greater than 0.1 mm and equal to or less than 0.5 mm.

Although not shown with reference to the above Figs. 1 to 6, the side wall can comprise a layered structure for preventing permeation of doping gas. The layered structure comprises alternating first layers and second layers. For example, the first layers comprise graphite and the second layers comprise refractory metal carbide.

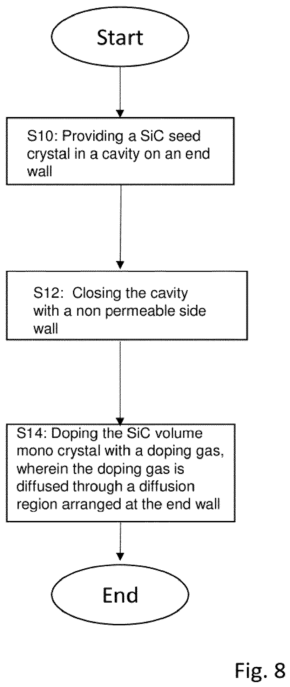

The method for growing such a SiC volume mono crystal by sublimation growth in a direction of growth is described in Fig. 8. According to the method, first in step S10 is provided a SiC seed crystal in the cavity. The SiC seed crystal is arranged at an end wall provided with a seed holder for holding the SiC seed crystal. The end wall extends perpendicular to the direction of growth. Additionally, SiC material is provided in a storage region formed in the cavity.

Then, the method proceeds with closing the cavity in Step S12. In particular, a side wall extending in the direction of growth surrounds the cavity. The side wall prevents permeation of a doping gas from an external into the cavity, the doping gas for doping the SiC volume mono crystal during the sublimation growth.

Then, the method proceeds with growing the SiC volume mono crystal in the cavity in Step S14. During growth, a doping gas is provided for doping the SiC volume mono crystal with the doping gas. The doping gas is diffused through a diffusion region allowing permeation of the doping gas from the external in the cavity, the diffusion region being located between the seed holder and an edge of the side wall.

In particular, the method for growing in the cavity the SiC volume mono crystal by sublimation growth in the direction of growth uses any crucible described above, for example in Figs. 1 to 7. Advantageously, the growth arrangement as described in above Figs, 1 to 7 is used for growing the SiC volume mono crystal.

## Claims

1. Crucible with a cavity for growing a SiC volume mono crystal by sublimation growth in a direction of growth (Y), the crucible comprising:
an end wall (110) with a seed holder (112) for holding a SiC seed crystal in the cavity, the end wall (110) extending in a direction (r) perpendicular to the direction of growth (Y);
a side wall (140) extending in the direction of growth (Y), the side wall (140) preventing permeation of a doping gas from an external into the cavity, the doping gas for doping the SiC volume mono crystal during the sublimation growth; and
a diffusion region (114) allowing permeation of the doping gas from the external in the cavity, wherein the diffusion region (114) is located between the seed holder (112) and an edge (142) of the side wall (140).

2. Crucible according to claim 1, wherein the side wall (140) comprises a material for preventing permeation of doping gas, the material comprising at least one of: graphite with a density of equal to or greater than 1.8 g/cm³, glass like carbon, and refractory metal carbide, optionally wherein the material comprises graphite with a density of equal to or greater than 1.85 g/cm³, and/or the material comprises graphite with a density of equal to or less than 1.9 g/cm³.

3. Crucible according to any of the preceding claims, wherein the side wall (140) comprises a layer (144, 146) at least on one of an inner surface and an opposing outer surface, the layer for preventing permeation of the doping gas, the inner surface facing cavity.

4. Crucible according to claim 3, wherein the layer (144, 146) comprises at least one of: a photoresist, a graphitized sugar layer, TaC, WC, and Ta4HfC5.

5. Crucible according to any of claims 4 to 5, wherein the layer (144, 146) has a thickness of equal to or greater than 0.5 µm, preferably the thickness is equal to or greater than 1 µm, even more preferably the thickness is equal to or greater than 2 µm, optionally wherein the maximum thickness is equal to or less than 5 µm.

6. Crucible according to any of the preceding claims, wherein the side wall (140) comprises a layered structure for preventing permeation of doping gas, the layered structure comprises alternating first layers and second layers, optionally wherein the first layers comprise graphite and the second layers comprise metal carbide.

7. Crucible according to any of the preceding claims, wherein the end wall (110) comprises the diffusion region (114), optionally wherein the diffusion region (114) forms an annular ring around the seed holder.

8. Crucible according to claim 7, wherein an area of the diffusion region (114) relative to an inner surface of the end wall (110) is equal to or greater than 20 % and equal to or less than 40 %, the inner surface of the end wall (110) facing the cavity, advantageously, the area of the diffusion region (114) relative to the inner surface of the end wall (110) is equal to or greater than 25 % and equal to or less than 35 %.

9. Crucible according to any of the preceding claims further comprising a sealing element (180), the sealing element (180) for sealing a contact region (172) between the end wall (110) and the edge (142) of the side wall (140) thereby reducing the permeation of the doping gas through the contact region (172).

10. Crucible according to any of the preceding claims further comprising a fastening element (170), the fastening element (170) for fastening the end wall (110) to the side wall (140) and thereby adjusting the permeation rate of the doping gas through a contact region (172) between the end wall (119) and the edge (142) of the side wall (140).

11. Crucible according to claim 10, wherein during the growth of the SiC volume mono crystal, a gap (190) is formed between the end wall (110) and the edge (142) of the side wall (140), the gap (190) for passing doping gas, preferably wherein the gap is equal to or greater than 0.1 mm and equal to or less than 0.5 mm.

12. Crucible according to any of the preceding claims further comprising a bottom wall (150, 151), wherein the bottom wall (150, 151) extending in a direction (r) perpendicular to the direction of growth (Y) so that the bottom wall encloses together with the end wall (110) and the side wall (140) the cavity;
wherein the bottom wall (151) comprises a second seed holder (152) for holding a second SiC seed crystal in the cavity and the crucible comprises a second diffusion region (154) allowing permeation of the doping gas, the second diffusion region (154) being located between the second seed holder (152) and a second edge (148) of the side wall (140);
or
wherein the bottom wall (150) is not detachably connected to the side wall (140) thereby forming a pot, the pot preventing permeation of a doping gas from an external into the cavity; optionally wherein an outer surface of the bottom wall is connected to a stand (210), the stand (210) for holding the crucible in a growth arrangement (10) and thereby preventing the permeation of the doping gas from the external into the cavity through the bottom wall (150), the outer surface facing the external.

13. Growth arrangement (10) comprising:
a crucible according to any of the preceding claims;
a reactor (200) forming a chamber, wherein the crucible is arranged in the chamber; and
a gas inlet (600) for feeding the chamber with the doping gas; optionally wherein the growth arrangement (10) further comprises at least one of a heating (400), wherein the heating surrounds the side wall (140) to inductively heat the side wall (140), and a gas outlet (500) for connecting to a vacuum pump for reducing the pressure in the chamber.

14. Method for growing in a cavity at least one SiC volume mono crystal by sublimation growth in a direction of growth (Y), the method comprising the steps of:
Providing a SiC seed crystal in the cavity, wherein the SiC seed crystal is arranged at an end wall (110) provided with a seed holder (112) for holding the SiC seed crystal, the end wall (110) extending in a direction (r) perpendicular to the direction of growth (Y);
Closing the cavity with a side wall (140) extending in the direction of growth (Y), the side wall (140) preventing permeation of a doping gas from an external into the cavity, the doping gas for doping the SiC volume mono crystal during the sublimation growth; and
Doping the SiC volume mono crystal with the doping gas, wherein the doping gas is diffused through a diffusion region (114) allowing permeation of the doping gas from the external in the cavity, the diffusion region (114) being located between the seed holder (112) and an edge (114) of the side wall (110).

15. Method for growing in a cavity at least one SiC volume mono crystal by sublimation growth in a direction of growth, the method comprising the steps of:
Providing a crucible according to any of claim 1 to 12 or a growth arrangement (10) according to claim 13, and
Growing the SiC volume mono crystal with the method of claim 14.

## Amended claims

### Amended claims in accordance with Rule 137(2) EPC.

1. Crucible with a cavity for growing a SiC volume mono crystal by sublimation growth in a direction of growth (Y), the crucible comprising:
an end wall (110) with a seed holder (112) for holding a SiC seed crystal in the cavity, the end wall (110) extending in a direction (r) perpendicular to the direction of growth (Y);
a side wall (140) extending in the direction of growth (Y), the side wall (140) preventing permeation of a doping gas from an external into the cavity, the doping gas for doping the SiC volume mono crystal during the sublimation growth; and
a diffusion region (114) allowing permeation of the doping gas from the external in the cavity, wherein the diffusion region (114) is located between the seed holder (112) and an edge (142) of the side wall (140),
wherein the side wall (140) is infiltrated and/or coated with material for preventing the permeation of the doping gas.

2. Crucible according to claim 1, wherein the side wall (140) comprises a material for preventing permeation of doping gas, the material comprising at least one of: graphite with a density of equal to or greater than 1.8 g/cm³, glass like carbon, and refractory metal carbide, optionally wherein the material comprises graphite with a density of equal to or greater than 1.85 g/cm³, and/or the material comprises graphite with a density of equal to or less than 1.9 g/cm³.

3. Crucible according to any of the preceding claims, wherein the side wall (140) comprises a layer (144, 146) at least on one of an inner surface and an opposing outer surface, the layer for preventing permeation of the doping gas, the inner surface facing cavity.

4. Crucible according to claim 3, wherein the layer (144, 146) comprises at least one of: a photoresist, TaC, WC, and Ta4HfC5.

5. Crucible according to any of claims 4, wherein the layer (144, 146) has a thickness of equal to or greater than 0.5 µm, preferably the thickness is equal to or greater than 1 µm, even more preferably the thickness is equal to or greater than 2 µm, optionally wherein the maximum thickness is equal to or less than 5 µm.

6. Crucible according to any of the preceding claims, wherein the side wall (140) comprises a layered structure for preventing permeation of doping gas, the layered structure comprises alternating first layers and second layers, optionally wherein the first layers comprise graphite and the second layers comprise metal carbide.

7. Crucible according to any of the preceding claims, wherein the end wall (110) comprises the diffusion region (114), optionally wherein the diffusion region (114) forms an annular ring around the seed holder.

8. Crucible according to claim 7, wherein an area of the diffusion region (114) relative to an inner surface of the end wall (110) is equal to or greater than 20 % and equal to or less than 40 %, the inner surface of the end wall (110) facing the cavity, advantageously, the area of the diffusion region (114) relative to the inner surface of the end wall (110) is equal to or greater than 25 % and equal to or less than 35 %.

9. Crucible according to any of the preceding claims further comprising a sealing element (180), the sealing element (180) for sealing a contact region (172) between the end wall (110) and the edge (142) of the side wall (140) thereby reducing the permeation of the doping gas through the contact region (172).

10. Crucible according to any of the preceding claims further comprising a fastening element (170), the fastening element (170) for fastening the end wall (110) to the side wall (140) and thereby adjusting the permeation rate of the doping gas through a contact region (172) between the end wall (119) and the edge (142) of the side wall (140).

11. Crucible according to claim 10, wherein during the growth of the SiC volume mono crystal, a gap (190) is formed between the end wall (110) and the edge (142) of the side wall (140), the gap (190) for passing doping gas, preferably wherein the gap is equal to or greater than 0.1 mm and equal to or less than 0.5 mm.

12. Crucible according to any of the preceding claims further comprising a bottom wall (150, 151), wherein the bottom wall (150, 151) extending in a direction (r) perpendicular to the direction of growth (Y) so that the bottom wall encloses together with the end wall (110) and the side wall (140) the cavity;
wherein the bottom wall (151) comprises a second seed holder (152) for holding a second SiC seed crystal in the cavity and the crucible comprises a second diffusion region (154) allowing permeation of the doping gas, the second diffusion region (154) being located between the second seed holder (152) and a second edge (148) of the side wall (140);
or
wherein the bottom wall (150) is not detachably connected to the side wall (140) thereby forming a pot, the pot preventing permeation of a doping gas from an external into the cavity; optionally wherein an outer surface of the bottom wall is connected to a stand (210), the stand (210) for holding the crucible in a growth arrangement (10) and thereby preventing the permeation of the doping gas from the external into the cavity through the bottom wall (150), the outer surface facing the external.

13. Growth arrangement (10) comprising:
a crucible with a cavity for growing a SiC volume mono crystal by sublimation growth in a direction of growth (Y), the crucible comprising:
an end wall (110) with a seed holder (112) for holding a SiC seed crystal in the cavity, the end wall (110) extending in a direction (r) perpendicular to the direction of growth (Y);
a side wall (140) extending in the direction of growth (Y), the side wall (140) preventing permeation of a doping gas from an external into the cavity, the doping gas for doping the SiC volume mono crystal during the sublimation growth; and a diffusion region (114) allowing permeation of the doping gas from the external in the cavity, wherein the diffusion region (114) is located between the seed holder (112) and an edge (142) of the side wall (140);
a reactor (200) forming a chamber, wherein the crucible is arranged in the chamber; and a gas inlet (600) for feeding the chamber with the doping gas; optionally wherein the growth arrangement (10) further comprises at least one of a heating (400), wherein the heating surrounds the side wall (140) to inductively heat the side wall (140), and a gas outlet (500) for connecting to a vacuum pump for reducing the pressure in the chamber.

14. Method for growing in a cavity at least one SiC volume mono crystal by sublimation growth in a direction of growth (Y), the method comprising the steps of:
Providing a SiC seed crystal in the cavity, wherein the SiC seed crystal is arranged at an end wall (110) provided with a seed holder (112) for holding the SiC seed crystal, the end wall (110) extending in a direction (r) perpendicular to the direction of growth (Y);
Closing the cavity with a side wall (140) extending in the direction of growth (Y), the side wall (140) preventing permeation of a doping gas from an external into the cavity, the doping gas for doping the SiC volume mono crystal during the sublimation growth; and
Doping the SiC volume mono crystal with the doping gas, wherein the doping gas is diffused through a diffusion region (114) allowing permeation of the doping gas from the external in the cavity, the diffusion region (114) being located between the seed holder (112) and an edge (114) of the side wall (110).

15. Method for growing in a cavity at least one SiC volume mono crystal by sublimation growth in a direction of growth, the method comprising the steps of:
Providing a crucible according to any of claim 1 to 12 or a growth arrangement (10) according to claim 13, and
Growing the SiC volume mono crystal with the method of claim 14.
